(19) Europäisches Patentamt
European Patent Office
Office européen des brevets

(11) **EP 4 498 685 A1**

(12) **EUROPEAN PATENT APPLICATION**
published in accordance with Art. 153(4) EPC

(43) Date of publication:
**29.01.2025 Bulletin 2025/05**

(21) Application number: **23773770.5**

(22) Date of filing: **20.03.2023**

(51) International Patent Classification (IPC):
**H04N 23/45** (2023.01)

(86) International application number:
**PCT/CN2023/082435**

(87) International publication number:
**WO 2023/179522 (28.09.2023 Gazette 2023/39)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **22.03.2022 CN 202210291666**

(71) Applicant: **VIVO MOBILE COMMUNICATION CO., LTD.**
**Dongguan, Guangdong 523863 (CN)**

(72) Inventor: **ZHU, Pengcheng**
**Dongguan, Guangdong 523863 (CN)**

(74) Representative: **Lavoix**
**Bayerstraße 83**
**80335 München (DE)**

(54) **CAMERA MODULE AND ELECTRONIC DEVICE**

(57) Embodiments of this application disclose a camera module and an electronic device. The camera module includes a color filter layer. The color filter layer includes an electrochromic region and a plurality of color filter regions. Each color filter region is used for transmitting a spectrum of a band corresponding to the color filter region. The electrochromic region has a fully light-transmissive state and a filter state. In the fully light-transmissive state, the electrochromic region is used for transmitting spectra of a plurality of different bands. In the filter state, the electrochromic region is used for transmitting spectra of a same band.

FIG. 2

**Description**

**CROSS-REFERENCE TO RELATED APPLICATIONS**

This application claims priority to Chinese Patent Application No. 202210291666.1, filed on March 22, 2022, which is incorporated herein by reference in its entirety.

**TECHNICAL FIELD**

This application pertains to the technical field of terminal devices and specifically relates to a camera module and an electronic device.

**BACKGROUND**

In recent years, the nightshot effect has gradually become an important selling point for many electronic devices such as smart phones. The key point of nightshot is to make a camera obtain more light input in a dark environment, so as to improve the brightness of photos taken. An amount of light input of the camera can be increased by increasing the aperture of a lens or sensitivity of an image sensor. However, for small electronic devices such as smart phones, due to the limitation on their own structural sizes, apertures of lenses will be limited to a certain size and cannot be increased any more. Therefore, improving sensitivity of image sensors has become an important technical development direction for improving the effect of taking pictures at night (in a dark environment).

In the related technology, the way to improve the sensitivity of image sensors is to replace some R, G and B pixels in image sensors with W pixels, which improves the photosensitivity in the dark environment. However, because W pixels are fully transmissive to incident light, this may lead to excessive photosensitivity. As a result, a problem of overexposure is caused to photos taken in a bright environment, and details in highlights of photos may lose after overexposure, affecting imaging quality.

**SUMMARY**

This application is intended to provide a camera module and an electronic device, so as to at least solve a problem that an existing camera module cannot adapt to dark light or bright shooting scenes due to poor photosensitivity.

According to a first aspect, an embodiment of this application provides a camera module. The camera module includes a color filter layer.

The color filter layer includes an electrochromic region and a plurality of color filter regions.

Each color filter region is used for transmitting a spectrum of a band corresponding to the color filter region.

The electrochromic region has a fully light-transmissive state and a filter state.

In the fully light-transmissive state, the electrochromic region is used for transmitting spectra of a plurality of different bands.

In the filter state, the electrochromic region is used for transmitting spectra of a same band.

According to a second aspect, an embodiment of this application provides an electronic device, where the electronic device includes the foregoing camera module.

In embodiments of this application, a solution is provided for the camera module to improve its photosensitivity so as to improve imaging quality in different shooting scenes. An appropriate quantity of electrochromic regions are added to the color filter layer and light-transmissive bands are adjusted for the electrochromic regions, to form a dynamically changeable color filter layer in the camera module. The color filter layer can have a plurality of different filter modes or fully light-transmissive modes, to adapt to different shooting scene requirements. In this way, an appropriate filter mode can be obtained through adjustment according to an actual shooting scene in both the bright environment and the dark environment, to obtain a better imaging effect.

Additional aspects and advantages of this application will be set forth in part in the following descriptions, and will become apparent in part in the following descriptions, or may be learned by practice of this application.

**BRIEF DESCRIPTION OF DRAWINGS**

The foregoing and/or additional aspects and advantages of this application will become apparent and easily understood from the descriptions of embodiments taken in combination with the accompanying drawings.

FIG. 1 is a first schematic structural diagram of a camera module according to an embodiment of this application;
FIG. 2 is a second schematic structural diagram of a camera module according to an embodiment of this application;

FIG. 3 is a third schematic structural diagram of a camera module according to an embodiment of this application;

FIG. 4 is a fourth schematic structural diagram of a camera module according to an embodiment of this application;

FIG. 5 is a schematic diagram of a working principle of a camera module according to an embodiment of this application;

FIG. 6 is a contrast diagram of a scene with complex colors (left) and a scene with monotonous colors (right); and

FIG. 7 is a schematic structural diagram of an electrochromic region according to an embodiment of this application.

Reference signs:

1. color filter layer; 11. color filter region; 111. first color filter region; 112. second color filter region; 113. third color filter region; 12. electrochromic region; 121. electrolyte layer; 122. electrochromic layer; 123. ion storage layer; 124. transparent conductive layer; 13. grid; 2. electrode structure; 21. first control electrode; 22. second control electrode; 3. driving device; 4. photosensitive layer; 5. micro lens layer.

## DESCRIPTION OF EMBODIMENTS

Embodiments of this application will be described in detail below, and examples of embodiments are shown in the accompanying drawings, where same or similar designations throughout indicate same or similar elements or elements having a same or similar function. Embodiments described below with reference to the accompanying drawings are examples and are used only for the purpose of explaining this application but are not construed as a limitation on this application. Based on embodiments in this application, all other embodiments obtained by persons of ordinary skill in the art without creative efforts fall within the protection scope of this application.

A feature modified by the term "first", "second", or the like in the specification and claims of this application can explicitly or implicitly include one or more such features. In the descriptions of this application, unless otherwise specified, "plurality" means two or more. In addition, "and/or" in the specification and claims represents at least one of connected objects, and the character "/" usually indicates that the associated objects have an "or" relationship.

In the descriptions of this application, it should be understood that the orientations or positional relationships indicated by the terms "center", "vertical", "transverse", "length", "width", "thickness", "upper", "lower", "front", "rear", "left", "right", "perpendicular", "horizontal", "top", "bottom", "inside", "outside", "clockwise", "counterclockwise", "axial", "radial", "circumferential", and the like are based on the orientations or positional relationships shown in the accompanying drawings, are merely intended to facilitate the descriptions of this application and simplify the descriptions, are not intended to indicate or imply that the means or components mentioned in this application must have specific orientations, or be constructed and operated for a specific orientation, and therefore shall not be construed as a limitation on this application.

In the descriptions of this application, it needs to be noted that, unless otherwise expressly provided and limited, the terms "mount", "join", and "connect" should be understood in a broad sense. For example, they may refer to a fixed, detachable, or integral connection, a mechanical connection, an electrical connection, a direct connection, an indirect connection through an intermediary medium, or a connection within two elements. Persons of ordinary skilled in the art can understand the specific meanings of the foregoing terms in this application in specific circumstances.

A camera module and an electronic device provided in embodiments of this application are described in detail below by using specific embodiments and application scenarios thereof in combination with the accompanying drawings.

According to an embodiment of this application, a camera module is provided. The camera module can be applied to various forms of electronic devices.

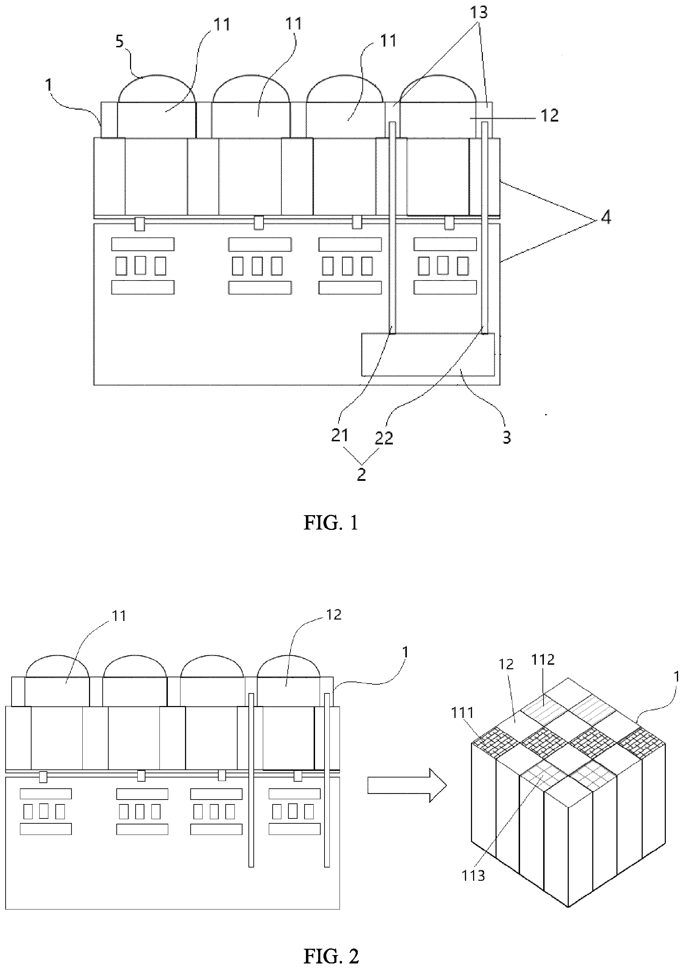

Refer to FIG. 1 to FIG. 4 for the camera module provided by this embodiment of this application. The camera module includes a color filter layer 1. The color filter layer 1 includes an electrochromic region 12 and a plurality of color filter regions 11.

Each color filter region 11 is used for transmitting a spectrum of a band corresponding to the color filter region 11.

The electrochromic region 12 has a fully light-transmissive state and a filter state.

In the fully light-transmissive state, the electrochromic region 12 is used for transmitting spectra of a plurality of different bands.

In the filter state, the electrochromic region 12 is used for transmitting spectra of a same band.

In this embodiment of this application, the color filter layer 1 is used in the camera module, and the color filter layer 1 is improved by adding an electrochromic material. The electrochromic region 12 is formed on the color filter layer 1 in addition to the plurality of color filter regions 11. Coloring and transparency of the electrochromic region 12 can be adjusted based on, for example, a change of a voltage. To be specific, the electrochromic region 12 can be decolored or colored (color added), so that the electrochromic region 12 can be switched between the filter state and the fully light-transmissive state. In other words, the electrochromic region 12 not only can be used as a filter but also can be adjusted to be a fully light-transmissive sheet. This makes the entire color filter layer 1 form a dynamically changeable color filter structure. This dynamically changeable color filter structure is different from a conventional colorfilter (CF).

For example, refer to FIG. 2. In a case that the camera module shoots in the dark environment, the electrochromic region 12 on the color filter layer 1 is adjusted to be in the fully light-transmissive state due to dark ambient light. In this way, an amount of light input of a camera can be increased to improve the shooting effect in dark light.

In FIG. 2, to distinguish the electrochromic region 12 and the color filter region 11 on the color filter layer 1, a plain box represents the electrochromic region 12, which is in the fully light-transmissive state, and a box filled with patterns represents the color filter region 11. As an example, FIG. 2 shows three different color filter regions 11 on the color filter layer 1, which are respectively a first color filter region 111, a second color filter region 112, and a third color filter region 113. For example, the first color filter region 111 is used for transmitting a red spectrum in visible light, the second color filter region 112 is used for transmitting a green spectrum in the visible light, and the third color filter region 113 is used for transmitting a blue spectrum in the visible light. In addition, the first color filter region 111, the second color filter region 112, and the third color filter region 113 each are provided in plurality. Since each electrochromic region 12 on the color filter layer 1 is in the fully light-transmissive state, fully light-transmissive pixels are added in the color filter layer 1, and these fully light-transmissive pixels can be used for transmitting the visible light. This can increase the amount of light input, to improve sensitivity of the camera module in the dark environment and improve brightness of photos taken in the dark environment.

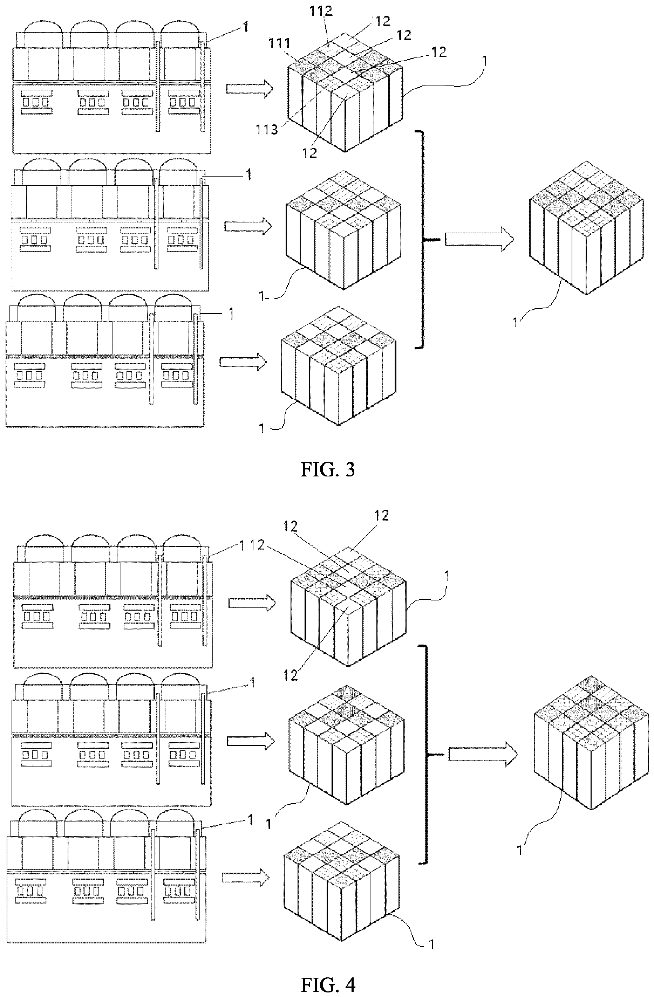

For example, refer to FIG. 3. In a case that the camera module shoots in the bright environment, at least part of the electrochromic regions 12 can be adjusted from a transparent fully light-transmissive state (plain box) to a colored filter state (plain box is filled with patterns) due to the bright ambient light. Because the electrochromic region 12 is used as a filter at this time, the electrochromic region can be used for transmitting a spectrum of a specified band, so that there are fewer fully light-transmissive pixels on the color filter layer 1, or there are no fully light-transmissive pixels at all (refer to the rightmost part in FIG. 3). This can reduce the amount of light input and avoid a problem of overexposure of photos taken in the bright environment.

After all electrochromic regions 12 on the color filter layer 1 are adjusted to the filter state, there may be more or richer color-transmissive regions (that is, color pixels) on the color filter layer 1, so that more scene color information can be obtained. In this way, the photographed photos can have better colors and better imaging quality. Especially, in the low brightness environment, the photographed photos will not have serious color noise problems.

Compared with an RGB pixel mode, an RGBW pixel mode will reduce a quantity of color pixels due to an increase in a quantity of fully light-transmissive pixels. However, in the solution of this application, a certain quantity of electrochromic regions 12 are added to the color filter layer 1, so that a filter mode of the color filter layer 1 can be dynamically adjusted by adjusting usage states of the electrochromic regions 12, thereby addressing the deficiency.

In this embodiment of this application, on the color filter layer 1, in a case that the electrochromic region 12 is in the filter state, a spectrum that can be transmitted by the electrochromic region can also be designed to be different from that transmitted by each color filter region 11, so as to enrich types of color pixels.

For example, the plurality of color filter regions 11 can transmit a red spectrum, a green spectrum, and a blue spectrum, respectively, while the electrochromic region 12 can transmit, in the filter state, a pink spectrum, a yellow spectrum, or another spectrum that is different from those transmitted by the plurality of color filter regions 11, so as to enrich the types of color pixels.

It should be noted that on the color filter layer 1, a certain quantity of electrochromic regions 12 can be controlled to be in the filter state as required, while remaining electrochromic regions 12 are in the fully light-transmissive state, that is, are light-transmissive pixels. This is not limited in this embodiment of this application.

For example, refer to an illustration in the upper part in the middle of FIG. 3. All three electrochromic regions 12 around the first color filter region 111 are converted to transmit a spectrum of a same band as the first color filter region 111, while the other electrochromic regions 12 on the color filter layer 1 are in the fully light-transmissive state.

For example, refer to an illustration in the middle part in the middle of FIG. 3. All three electrochromic regions 12 around the second color filter region 112 are converted to transmit a spectrum of a same band as the second color filter region 112, while the other electrochromic regions 12 on the color filter layer 1 are in the fully light-transmissive state.

For example, refer to an illustration in the lower part in the middle of FIG. 3. All three electrochromic regions 12 around the third color filter region 113 are converted to transmit a spectrum of a same band as the third color filter region 113, while the other electrochromic regions 12 on the color filter layer 1 are in the fully light-transmissive state.

In this embodiment of this application, in a case that all the electrochromic regions 12 on the color filter layer 1 are in the fully light-transmissive state, each electrochromic region 12 is used for transmitting spectra of a plurality of different bands. For example, in a case that the electrochromic region 12 is in the fully light-transmissive state, visible light can directly pass through the electrochromic region. This design can increase an amount of light input for the camera module to meet the shooting needs in dark scenes.

In this embodiment of this application, in a case that the electrochromic regions 12 on the color filter layer 1 are at least partially in the filter state, each electrochromic region 12 can be used for transmitting a spectrum of a band corresponding to the electrochromic region 12. For example, in a case that the electrochromic region 12 is in the filter state and is configured to filter out green light and blue light in the visible light, the electrochromic region 12 allows only red light in the visible light to pass through, but the green light and the blue light in the visible light cannot pass through the electrochromic region 12. This design can increase a quantity of color pixels and reduce an amount of light input, which is conducive to taking more colorful photos in bright scenes.

In this embodiment of this application, a solution is provided for the camera module to improve its photosensitivity so as to improve imaging quality in different shooting scenes. An appropriate quantity of electrochromic regions 12 are added to the color filter layer 1 and light-transmissive bands are adjusted for the electrochromic regions 12, to form a dynamically changeable color filter layer 1 in the camera module. The color filter layer 1 can have a plurality of different filter modes or fully light-transmissive modes, to adapt to different shooting scene requirements. In this way, an appropriate filter mode can be obtained through adjustment according to an actual shooting scene in both the bright environment and the dark environment, to obtain a better imaging effect.

In other words, in this embodiment of this application, light transmittance of the color filter layer 1 can be dynamically adjusted by adjusting the electrochromic region 12 to switch between the filter state and the fully light-transmissive state, which can adapt to various complicated and changeable shooting environments. This embodiment of this application can give consideration to the dark environment, the bright environment and the service environment with complex colors at the same time, which is different from a conventional color filter layer with a fixed array arrangement.

In some examples of this application, refer to FIG. 2 and FIG. 3. An arrangement manner of the color filter region 11 on the color filter layer 1 includes at least one of the following:

One or more of the electrochromic regions 12 are arranged on at least one side of each of the color filter region 11 and one or more of the electrochromic regions 12 are arranged between two adjacent color filter regions 11.

For example, refer to FIG. 2 and FIG. 3. The color filter layer 1 includes a plurality of first color filter regions 111, a plurality of second color filter regions 112, and a plurality of third color filter regions 113, which are arranged at different positions on the color filter layer 1 to form a specific color filter array. The first color filter region 111 is used for outputting red light in the visible light, the second color filter region 112 is used for outputting green light in the visible light, and the third color filter region 113 is used for outputting blue light in the visible light. On this basis, a plurality of electrochromic regions 12 are simultaneously arranged on the color filter layer 1, and these electrochromic regions 12 are arranged among the first color filter regions 111, the second color filter regions 112, and the third color filter regions 113. In this way, after at least part of the electrochromic regions 12 are adjusted to the filter state, a quantity of required color filter regions can be correspondingly increased on the color filter layer 1. In a case that at least part of the electrochromic regions 12 are adjusted to the fully light-transmissive state, fully light-transmissive pixels can be correspondingly added on the color filter layer 1.

It should be noted that a specific arrangement of the plurality of color filter regions 11 and the plurality of electrochromic regions 12 on the color filter layer 1 can be flexibly adjusted by those skilled in the art according to an actual situation. This embodiment of this application is not specifically limited herein, that is, is not limited to the examples shown in FIG. 2 and FIG. 3.

In some examples of this application, refer to FIG. 3. On the color filter layer 1, in a case that the electrochromic region 12 is in the filter state, the electrochromic region 12 is configured to be capable of transmitting spectra of a same band as one of the adjacent color filter regions 11.

For example, refer to the illustration in the upper part in the middle of FIG. 3. On the color filter layer 1, the electrochromic regions 12 around the first color filter region 111 are configured to be capable of transmitting, in the filter state, a spectrum of a same band as the first color filter region 111. In this way, a quantity of first color filter regions 111 can be increased on the color filter layer 1. Similarly, a quantity of second color filter regions 112 and a quantity of third color filter regions 113 can also be increased on the color filter layer 1. Details are not repeated in this application.

In some examples of this application, refer to FIG. 4. On the color filter layer 1, in a case that the electrochromic region 12 is in the filter state, the electrochromic region 12 is configured to transmit a spectrum of a different band from any color filter region 11.

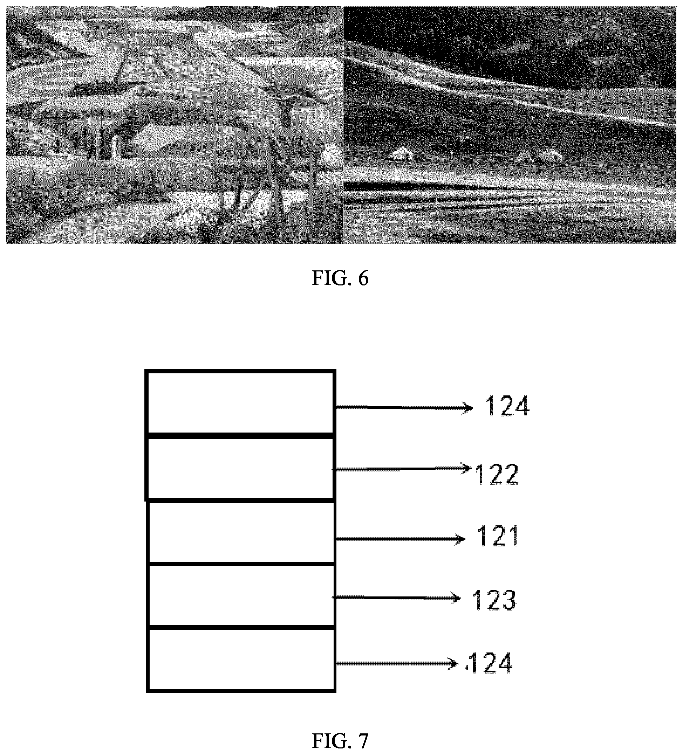

In a mixed color environment, refer to a left view and a right view (both original images are color images) in FIG. 6, and the left view is more colorful. At this time, the electrochromic regions 12 on the color filter layer 1 is adjusted to the filter state and configured to transmit light different from that transmitted by any color filter region 11, as shown in FIG. 4. In this case, the color-transmissive array arranged on the color filter layer 1 can be changed to an arrangement mode with more color channels, for example, an RGBCMY arrangement mode. With an increase in color channels, the camera module can obtain richer color information, so that a real color of a scene can be better restored.

For example, on the color filter layer 1, different color filter regions 11, to be specific, the first color filter region 111, the second color filter region 112, and the third color filter region 113 respectively transmit the red spectrum, the green spectrum, and the blue spectrum in the visible light, and the plurality of electrochromic regions 12 can respectively transmit a pink spectrum, a yellow spectrum, and a purple spectrum after filtering, as shown in the right view in FIG. 4. In this way, six color filter channels can be formed on the color filter layer 1 (FIG. 4 shows the six different filter channels by using six different patterns). In this way, a formed color filter layer 1 has more color channels, which is conducive to achieving better color restoration of images and enriching the color expression of the camera module.

In some examples of this application, the electrochromic region 12 is provided in plurality, where in the filter state, electrochromic regions 12 used for transmitting spectra of a same band are connected to each other, and are all connected to a same driving device 3, and the driving device 3 is configured to drive the connected electrochromic regions 12 to be switchable between the fully light-transmissive state and the filter state.

In other words, a plurality of electrochromic regions 12 are arranged on the color filter layer 1, a part of the electrochromic regions 12 can transmit a spectrum of a same band in the filter state, and these electrochromic regions 12 are connected together and are driven and controlled by the driving device 3.

For example, a plurality of electrochromic regions 12 are arranged on the color filter layer 1, and the plurality of electrochromic regions 12 are divided into three groups, namely, a group A, a group B, and a group C. Each electrochromic region 12 in the group A is used for outputting a red spectrum in visible light in a case of being adjusted to the filter state, and electrochromic regions 12 in the group A are connected together and connected to a driving device A. Each electrochromic region 12 in the group B is used for outputting a green spectrum in the visible light in a case of being adjusted to the filter state, and electrochromic regions 12 in the group B are connected together and connected to a driving device B. Each electrochromic region 12 in the group C is used for outputting a blue spectrum in the visible light in a case of being adjusted to the filter state, and electrochromic regions 12 in the group C are connected together and connected to a driving device C. On this basis, the driving device A is configured to control the electrochromic regions 12 in the group A to be switchable between the fully light-transmissive state and the filter state, the driving device B is configured to control the electrochromic regions 12 in the group B to be switchable between the fully light-transmissive state and the filter state, and the driving device C is configured to control the electrochromic regions 12 in the group C to be switchable between the fully light-transmissive state and the filter state.

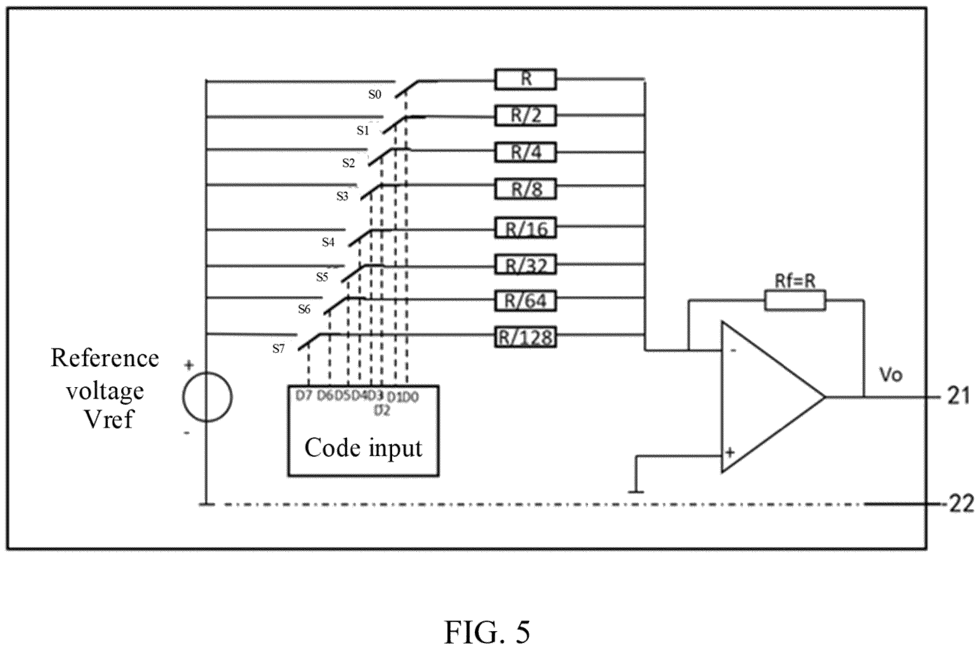

Refer to FIG. 5. An operating core of the driving device 3 is a digital analog converter (DAC), and a working principle thereof is as follows:

D7, D6, D5, ..., and D0 shown in FIG. 5 are all designed as 8-bit binary codes, and each bit can be set to 1 or 0. An output voltage Vo has the following relationship with an input digital code:

$$Vo = K * Vref * (D_7 * 2^7 + D_6 * 2^6 + D_5 * 2^5 + \cdots + D_0 * 2^0).$$

In the foregoing formula, the proportional coefficient K is a constant and can be determined by calibration. A calibration process is briefly described as follows:

Firstly, the camera module including the color filter layer 1 and a conventional RGB camera module are placed in a same QE test environment. As a benching object, the conventional RGB camera module can be calibrated with a QE curve in a G (filtered) band.

A value of K is adjusted to make a QE curve of the color filter layer 1 and the QE curve of the RGB camera module approach to a certain error range, to obtain an accurate value of K.

To drive and control different electrochromic regions 12 on the color filter layer 1, an independent driving device 3 can be provided for each electrochromic region 12.

Specifically, a plurality of electrochromic regions 12 are arranged on the color filter layer 1, where a part of the electrochromic regions 12 can be converted to be in a same filter state as the first color filter region 111 (that is, transmit a spectrum of a same band as the first color filter region 111), a part of the electrochromic regions 12 can be converted to be in a same filter state as the second color filter region 112 (that is, transmit a spectrum of a same band as the second color filter region 112). and a part of the electrochromic regions 12 can be converted to be in a same filter state as the third color filter region 113 (that is, transmit a spectrum of a same band as the third color filter region 113). On this basis, three driving device can be equipped accordingly. Certainly, this embodiment of this application is not limited to this arrangement manner.

In a specific example of this application, a process of adjusting transmittance of the color filter layer 1 including the electrochromic region 12 is as follows, in which coding control is added:

    (1) In the dark environment, brightness of the current shooting environment can be determined according to an auto exposure (AE) strategy of a mobile phone, and an auto exposure AE threshold can be set according to specific needs.

In a case that environment brightness is lower than 10 lux, the dark environment is determined at this time. The driving device 3 is controlled to perform code input: 00000000, so that the electrochromic regions 12, for example, have no driving voltage. In this case, as shown in FIG. 2, each electrochromic region 12 on the color filter layer 1 is in a transparent state, that is, a plurality of fully light-transmissive pixels are formed on the color filter layer 1, so as to improve sensitivity of the camera module in the dark environment.

(2) In the bright environment, as shown in FIG. 3, there are three driving device 3: a driving device A, a driving device B, and a driving device C. The driving device A, B, and C are driven and controlled to be turned on, so that a plurality of electrochromic regions 12 on the color filter layer 1 are all in a filter state and can separately transmit control codes corresponding to, for example, R pixels, G pixels, and B pixels. In this case, there are no fully light-transmissive pixels on the color filter layer 1. This can avoid overexposure caused by existence of fully light-transmissive pixels. Moreover, the camera module can obtain more color information and avoid a problem of color noise.

For example, in a case that the driving device A outputs a code 01111111, the electrochromic region 12 controlled by the driving device A can transmit the green spectrum in the filter state; in a case that the driving device B outputs a code 00011111, the electrochromic region 12 controlled by the driving device B can transmit the blue spectrum in the filter state; and in a case that the driving device C outputs a code 11101111, the electrochromic region 12 controlled by the driving device C can transmit the red spectrum in the filter state.

It should be noted that specific coded data needs to be calibrated and determined, and is not limited to the foregoing examples.

(3) In an environment with complex colors:

Refer to FIG. 4. In an environment with complex colors, in a case that a photographed object includes red, green, blue, purple, cyan, yellow and other colors, color information of the photographed object can be obtained through some open source tools (for example, Color Copy Paste). Based on the obtained color information, color complexity of the currently photographed object can be determined, and then the driving device is controlled to implement arrangement of, for example, RGBCMY (red, green, blue, magenta, cyan, and yellow). More color channels allow the camera module to achieve better color restoration in the environment with complex colors, thereby greatly enriching color performance of image sensors.

For example, in a case that the driving device A outputs a code 10001100, the electrochromic region 12 controlled by the driving device A can transmit the yellow spectrum in the filter state; in a case that the driving device B outputs a code 00101111, the electrochromic region 12 controlled by the driving device B can transmit the cyan spectrum in the filter state; and in a case that the driving device C outputs a code 11000000, the electrochromic region 12 controlled by the driving device C can transmit the magenta spectrum in the filter state.

It should be noted that specific coded data needs to be calibrated and determined, and is not limited to the foregoing examples.

In some examples of this application, refer to FIG. 1, the camera module further includes an electrode structure 2 and a driving device 3 connected to the electrode structure 2. The electrode structure 2 includes a first control electrode 21 and a second control electrode 22, where the first control electrode 21 and the second control electrode 22 are separately connected to the electrochromic region 12. The driving device 3 is configured to apply a control voltage or a control current to the electrode structure 2 and drive, via the electrode structure 2, the electrochromic region 12 to be switchable between the fully light-transmissive state and the filter state.

One of the first control electrode 21 and the second control electrode 22 is a positive electrode, and the other is a negative electrode. The driving device 3 can be electrically connected to the electrochromic region 12 through the electrode structure 2, so as to drive the connected electrochromic region 12 to be switchable between the fully light-transmissive state and the filter state.

The driving device 3 can control the electrification of the electrode structure 2 to provide different voltages or different currents for the electrochromic region 12. In this way, the electrochromic region 12 can be in different working states under the control of different voltages or currents. In some examples of this application, refer to FIG. 1. A grid 13 is provided on a periphery of the electrochromic region 12, the first control electrode 21 and the second control electrode 22 are oppositely arranged on two sides of the electrochromic region 12 respectively, and both are at least partially inserted into the grid 13.

Among them, the grid 13 is made of metal, that is, a metal grid, which can be used for isolating transmission areas of different colors on the color filter layer 1, and can prevent light crosstalk.

In this embodiment of this application, the grid 13 is not limited to be arranged on a peripheral side of the electrochromic region 12, and the grid 13 may be arranged between different color-transmissive regions.

In this embodiment of this application, the grid 13 is used for accommodating the electrode structure 2, so that the electrode structure 2 does not occupy space on a surface of the color filter layer 1 during arrangement.

In some examples of this application, refer to FIG. 1. The camera module further includes a photosensitive layer 4 and a micro lens layer 5. The color filter layer 1 covers the photosensitive layer 4, and the driving device 3 is arranged in the photosensitive layer 4. The micro lens layer 5 covers the color filter layer 1.

The photosensitive layer 4 includes a photodiode layer, a DTI (deep trench isolation), and a logic circuit layer. The photodiode converts an optical signal filtered by the color filter layer into an electrical signal. The DTI, namely, deep trench isolation, is configured to isolate the photodiode and prevent light crosstalk. The logic circuit layer processes the electrical signal converted by the photodiode.

The driving device 3 is arranged in the photosensitive layer 4 (for example, the logic circuit layer) of the camera module, used as an independent module, and can apply a control voltage to the electrochromic region 12.

The micro lens layer 5 covers the color filter layer 1, and incident light passes through the micro lens layer 5 and the color filter layer 1 in sequence and then is transmitted to the photosensitive layer 4. The micro lens layer 5 is configured to condense light to obtain more light input.

In some examples of this application, refer to FIG. 7. The electrochromic region 12 includes an electrolyte layer 121, an electrochromic layer 122, an ion storage layer 123, and two transparent conductive layers 124. The electrochromic layer 122 and the ion storage layer 123 are respectively arranged on two surfaces of the electrolyte layer 121. The two transparent conductive layers 124 respectively cover the electrochromic layer 122 and the ion storage layer 123.

The electrochromic region 12 undergoes a redox reaction driven by an applied voltage, so that a color of a material changes, and the color tends to be stable after the reaction is balanced.

Optionally, a material of the electrochromic region 12 is tungsten oxide ($WO_3$).

For example, tungsten oxide is the material of the electrochromic region 12. A principle of color adjustment of the electrochromic region 12 is explained.

Decolorization of the electrochromic region 12: After a specified voltage is applied to the electrochromic region 12, ions and electrons in the ion storage layer 123 move out of the electrochromic layer 122, and chemical valences of a part of W change from +5 to +6, thereby making a color lighter and forming a transparent state.

According to another embodiment of this application, an electronic device is provided.

The electronic device includes the foregoing camera module.

The electronic device may be a terminal, or may be another device different from the terminal. For example, the electronic device may be, for example, a mobile phone, a tablet computer, a notebook computer, a palm computer, a vehicle-mounted electronic device, a mobile internet device (Mobile Internet Device, MID), an augmented reality (augmented reality, AR)/virtual reality (virtual reality, VR) device, a robot, a wearable device, an ultra-mobile personal computer (ultra-mobile personal computer, UMPC), a netbook, or a personal digital assistant (personal digital assistant, PDA), or may be a server, a network attached storage (Network Attached Storage, NAS), a personal computer (personal computer, PC), a television (television, TV), a teller machine, or a self-service machine. This embodiment of this application is not specifically limited herein.

Other compositions and operations of the electronic device according to this embodiment of this application are known to persons of ordinary skilled in the art, and will not be described in detail herein.

In the descriptions of this specification, descriptions of reference terms such as "one embodiment", "some embodiments", "example embodiment", "example", "specific example", or "some examples" mean that specific features, structures, materials or characteristics described with reference to embodiments or examples are included in at least one embodiment or example of this application. In this specification, schematic expressions of the foregoing terms do not necessarily refer to a same embodiment or example. Moreover, the specific features, structures, materials or characteristics described may be combined in any one or more embodiments or examples in a suitable manner.

Although embodiments of this application have been shown and described, persons of ordinary skilled in the art can understand that many changes, modifications, substitutions, and variations can be made to these embodiments without departing from the principles and purposes of this application, and the scope of this application is defined by the claims and their equivalents.

**Claims**

1. A camera module, wherein the camera module comprises a color filter layer (1); wherein

   the color filter layer (1) comprises an electrochromic region (12) and a plurality of color filter regions (11);
   each color filter region (11) is used for transmitting a spectrum of a band corresponding to the color filter region (11);
   the electrochromic region (12) has a fully light-transmissive state and a filter state;
   in the fully light-transmissive state, the electrochromic region (12) is used for transmitting spectra of a plurality of different bands; and
   in the filter state, the electrochromic region (12) is used for transmitting spectra of a same band.

2. The camera module according to claim 1, wherein an arrangement manner of the color filter region (11) on the color filter layer (1) comprises at least one of the following:
   one or more of the electrochromic regions (12) are arranged on at least one side of each of the color filter region (11) and one or more of the electrochromic regions (12) are arranged between two adjacent color filter regions (11).

3. The camera module according to claim 2, wherein in a case that the electrochromic region (12) is in the filter state, the electrochromic region (12) is configured to be capable of transmitting spectra of a same band as one of the adjacent color filter regions (11).

4. The camera module according to claim 2, wherein in a case that the electrochromic region (12) is in the filter state, the electrochromic region (12) is configured to transmit a spectrum of a different band from any of the color filter regions (11).

5. The camera module according to claim 1, wherein the electrochromic region (12) is provided in plurality, wherein in the filter state, electrochromic regions (12) used for transmitting spectra of a same band are connected to each other, and are all connected to a same driving device (3), and the driving device (3) is configured to drive the connected electrochromic regions (12) to be switchable between the fully light-transmissive state and the filter state.

6. The camera module according to claim 1, wherein the camera module further comprises an electrode structure (2) and a driving device (3) connected to the electrode structure (2); wherein

the electrode structure (2) comprises a first control electrode (21) and a second control electrode (22), wherein the first control electrode (21) and the second control electrode (22) are connected to the electrochromic region (12), respectively; and
the driving device (3) is configured to apply a control voltage or a control current to the electrode structure (2) and drive, via the electrode structure (2), the electrochromic region (12) to be switchable between the fully light-transmissive state and the filter state.

7. The camera module according to claim 6, wherein a grid (13) is provided on a periphery of the electrochromic region (12), the first control electrode (21) and the second control electrode (22) are oppositely arranged on two sides of the electrochromic region (12) respectively, and both are at least partially inserted into the grid (13).

8. The camera module according to claim 6, wherein the camera module further comprises a photosensitive layer (4) and a micro lens layer (5); wherein

the color filter layer (1) covers the photosensitive layer (4), and the driving device (3) is arranged in the photosensitive layer (4); and
the micro lens layer (5) covers the color filter layer (1).

9. The camera module according to any one of claims 1 to 8, wherein the electrochromic region (12) comprises:

an electrolyte layer (121);
an electrochromic layer (122) and an ion storage layer (123), wherein the electrochromic layer (122) and the ion storage layer (123) are respectively arranged on two surfaces of the electrolyte layer (121); and
two transparent conductive layers (124), wherein the two transparent conductive layers (124) respectively cover the electrochromic layer (122) and the ion storage layer (123).

10. An electronic device, comprising the camera module according to any one of claims 1 to 9.

FIG. 1

FIG. 2

FIG. 3

FIG. 4

FIG. 5

FIG. 6

FIG. 7

**INTERNATIONAL SEARCH REPORT**

International application No.

**PCT/CN2023/082435**

| A. | CLASSIFICATION OF SUBJECT MATTER |
|---|---|

H04N23/45(2023.01)i

According to International Patent Classification (IPC) or to both national classification and IPC

| B. | FIELDS SEARCHED |
|---|---|

Minimum documentation searched (classification system followed by classification symbols)

IPC:H04N

Documentation searched other than minimum documentation to the extent that such documents are included in the fields searched

Electronic data base consulted during the international search (name of data base and, where practicable, search terms used)

CNABS, CNTXT, ENTXTC, WPABS, WPABSC: 彩色滤光, 电致变色, 滤光, 全透光, 摄像模组, camera module, color filtering, electrochromism, light filtering, light transmission

| C. | DOCUMENTS CONSIDERED TO BE RELEVANT |
|---|---|

| Category* | Citation of document, with indication, where appropriate, of the relevant passages | Relevant to claim No. |
|---|---|---|
| PX | CN 114650358 A (VIVO COMMUNICATION TECHNOLOGY CO., LTD.) 21 June 2022 (2022-06-21) entire document | 1-10 |
| Y | US 2012257090 A1 (LG INNOTEK CO., LTD.) 11 October 2012 (2012-10-11) description, paragraphs [0023]-[0037] | 1-10 |
| Y | CN 112928148 A (VIVO COMMUNICATION TECHNOLOGY CO., LTD.) 08 June 2021 (2021-06-08) description, paragraphs [0027]-[0034] | 1-10 |
| A | CN 112822466 A (VIVO COMMUNICATION TECHNOLOGY CO., LTD.) 18 May 2021 (2021-05-18) entire document | 1-10 |
| A | US 2015221691 A1 (PANASONIC INTELLECTUAL PROPERTY MANAGEMENT CO., LTD.) 06 August 2015 (2015-08-06) entire document | 1-10 |

☐ Further documents are listed in the continuation of Box C. ☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **09 April 2023** | **23 April 2023** |

| Name and mailing address of the ISA/CN | Authorized officer |
|---|---|
| **China National Intellectual Property Administration (ISA/CN)** **China No. 6, Xitucheng Road, Jimenqiao, Haidian District, Beijing 100088** | |
| Facsimile No. **(86-10)62019451** | Telephone No. |

Form PCT/ISA/210 (second sheet) (July 2022)

INTERNATIONAL SEARCH REPORT
Information on patent family members

International application No.

**PCT/CN2023/082435**

| Patent document cited in search report | | | Publication date (day/month/year) | Patent family member(s) | | | Publication date (day/month/year) |
|---|---|---|---|---|---|---|---|
| CN | 114650358 | A | 21 June 2022 | None | | | |
| US | 2012257090 | A1 | 11 October 2012 | KR | 20120115888 | A | 19 October 2012 |
| | | | | KR | 101262507 | B1 | 08 May 2013 |
| | | | | US | 8896732 | B2 | 25 November 2014 |
| CN | 112928148 | A | 08 June 2021 | None | | | |
| CN | 112822466 | A | 18 May 2021 | None | | | |
| US | 2015221691 | A1 | 06 August 2015 | WO | 2014041742 | A1 | 20 March 2014 |
| | | | | US | 10014335 | B2 | 03 July 2018 |
| | | | | JPWO | 2014041742 | A1 | 12 August 2016 |
| | | | | JP | 6161007 | B2 | 12 July 2017 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202210291666